# EUROPEAN PATENT APPLICATION

(11) **EP 4 568 111 A1**
(43) Date of publication of application: **11.06.2025**
(21) Application number: 24206377.4
(22) Date of filing: 14.10.2024
(51) Int. Cl.: H03K 19/173, H03K 19/17728

(54) **TECHNIQUES FOR CONFIGURABLE SELECTION BETWEEN HARD LOGIC AND CONFIGURABLE LOGIC GATES**

(30) Priority: 06.12.2023 US 202318530665
(71) Applicant: Altera Corporation, San Jose, CA 95134 (US)
(72) Inventor: Ganusov, Ilya, San Jose CA, 95124 (US); Ng, Bee Yee, 11900 Bayan Lepas, Penang (MY); Chromczak, Jeffrey, Toronto ON, M8Z4M6 (CA); Zgheib, Grace, San Jose CA, 95134 (US)
(74) Representative: Samson & Partner Patentanwälte mbB

(57) **Abstract**

An integrated circuit includes a hard logic circuit block (313), a routing block (311), and a logic gate circuit block (312) that includes configurable logic gate circuits (302). The logic gate circuit block (312) is configurable to provide either first output signals of the configurable logic gate circuits to the routing block (302 through 303 to 311) or second output signals of the hard logic circuit block to the routing block (305 through 303 to 311).

## Description

### TECHNICAL FIELD

The present disclosure relates to electronic integrated circuits, and more particularly to techniques for configurable selection between hard logic blocks and configurable logic gate blocks in an integrated circuit.

### BACKGROUND

Configurable integrated circuits can be configured by users to implement desired custom logic functions. In a typical scenario, a logic designer uses computer-aided design (CAD) tools to design a custom circuit design. When the design process is complete, the computer-aided design tools generate configuration data. The configuration data is then loaded into configuration memory elements that configure configurable logic circuits in the integrated circuit to perform the functions of the custom circuit design. Configurable integrated circuits can be used for co-processing in big-data or fast-data applications. For example, configurable integrated circuits can be used in application acceleration tasks in a datacenter and can be reprogrammed during datacenter operation to perform different tasks.

### BRIEF DESCRIPTION OF DRAWINGS

Figure 1A is a diagram that depicts an example of a 4-input binary logic tree.
Figure 1B is a diagram that depicts an example of an 8-input binary logic tree.
Figure 2A is a diagram that depicts an example of a node logic circuit that can be used as any one or more of the node logic circuits in an And-Inverter Cone (AIC).
Figure 2B is a diagram that depicts another example of a node logic circuit that can be used as any one or more of the node logic circuits in an AIC.
Figure 2C is a diagram that depicts an example of a node logic circuit that can be used as any one or more of the node logic circuits in an OR-Inverter Cone (OIC).
Figure 2D is a diagram that depicts another example of a node logic circuit that can be used as any one or more of the node logic circuits in an OIC.
Figure 3 is a diagram that depicts an example of a logic gate block that is coupled in parallel with a hard intellectual property (IP) block in an integrated circuit (IC).
Figure 4 is a diagram of an illustrative example of a configurable integrated circuit (IC).
Figure 5 illustrates a block diagram of a system that can be used to implement a circuit design to be programmed onto a programmable logic device using design software.
Figure 6 is a diagram that depicts an example of a programmable logic device that includes a fabric die and a base die that are connected to one another via microbumps.
Figure 7 is a block diagram illustrating a computing system configured to implement one or more aspects of the embodiments described herein.

### DETAILED DESCRIPTION

In configurable integrated circuits, hard intellectual property (IP) circuit blocks, such as digital signal processing (DSP) circuit blocks and memory circuit blocks, have a high number of inputs and outputs (IOs) and a dedicated routing interconnect with high flexibility to deliver these IOs. Typically, the hard IP blocks are spread across the floorplan of a configurable integrated circuit in predetermined columns. A typical circuit design for a configurable integrated circuit (IC) may use several types of hard IP blocks. However, hard IP blocks tend to be underutilized in many circuit designs. As an example, most circuit designs for some types of configurable integrated circuits (ICs) do not use, or barely use, any of the DSP blocks available in the fabric area of the configurable ICs. When a hard IP block is not utilized in a circuit design, the area, inputs, outputs, and routing interconnects of the hard IP block are wasted.

And-Inverter Cones (AICs) are logic gate blocks that have a high number of inputs and outputs. The AIC is designed as a full binary tree of nodes, where each node is a NAND gate with programmable output inversion, to implement either a NAND or AND Boolean logic function of its two inputs. The nodes at the first level of the binary tree can also optionally have programmable input inversions or no inversions, depending on the integrated circuit architecture. AICs can have outputs at intermediate levels of the binary tree. AICs do not have the full flexibility to implement all possible logic functions that can be implemented by Look-Up Tables (LUTs). However, many of the combinatorial logic functions implemented by LUTs can be implemented by AICs. Also, AICs can implement simple large functions at a fraction of the area cost of Look-Up Tables (LUTs).

According to some examples disclosed herein, logic gate circuit blocks are coupled in parallel with hard intellectual property (IP) circuit blocks in an integrated circuit (IC), such as a configurable IC. Each of the logic gate circuit blocks shares the same inputs, outputs, and routing interconnects as a corresponding one of the hard IP circuit blocks. The inputs of each hard IP block are coupled to the inputs of a corresponding one of the logic gate circuit blocks. Multiplexers are coupled to select the outputs of either the hard IP circuit block or the corresponding logic gate circuit block. Each of the logic gate circuit blocks includes logic gate circuits that are configurable to perform various logic functions. AICs are examples of the logic gate circuits. The logic gate circuits can also be logic gate trees or cones that include other types of logic gates, such as NOR gates. The logic gate circuit blocks coupled in parallel with the hard IP circuit blocks can be any sizes and can be as large as the number of unique inputs of the corresponding hard IP circuit blocks. When the hard IP circuit blocks are unused in a circuit design for a configurable IC, the logic gate circuit blocks can be configured to implement logic functions for the circuit design, which increases the logic density and reduces the logic area needed to implement the circuit design.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the term "connected" means a direct electrical connection between the circuits that are connected, without any intermediary devices. The term "coupled" means either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

This disclosure discusses integrated circuit devices, including configurable (programmable) logic integrated circuits, such as field programmable gate arrays (FPGAs). As discussed herein, an integrated circuit (IC) can include hard logic and/or soft logic. The circuits in an integrated circuit device (e.g., in a configurable logic IC) that are configurable by an end user are referred to as "soft logic." "Hard logic" generally refers to circuits in an integrated circuit device that have substantially less configurable features than soft logic or no configurable features.

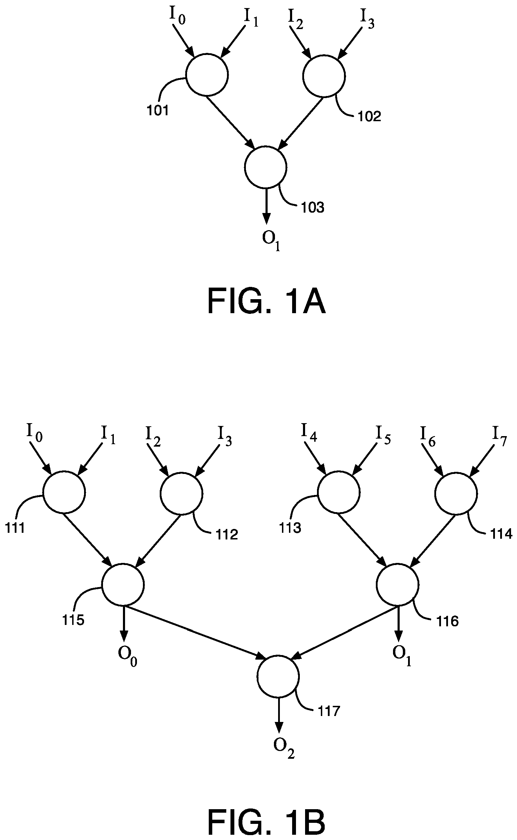

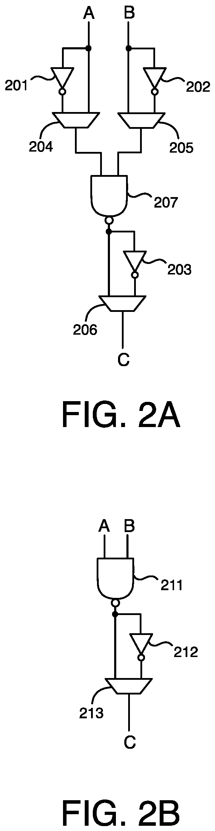

Figure 1A is a diagram that depicts an example of a 4-input binary logic tree. The binary logic tree of Figure (FIG.) 1A can be, as examples, an And-Inverter Cone (AIC) or an OR-Inverter Cone (OIC). The binary logic tree of FIG. 1A includes three node logic circuits 101-103 that function as nodes in the binary logic tree. Each of the node logic circuits 101-103 includes logic gates, examples of which are disclosed herein with respect to Figures 2A-2D. Node logic circuit 101 performs a logic function on its input signals I₀ and I₁, to generate an output signal that is provided to an input of node logic circuit 103. Node logic circuit 102 performs a logic function on its input signals I₂ and I₃ to generate an output signal that is provided to an input of node logic circuit 103. Node logic circuit 103 performs a logic function on the output signals of node logic circuits 101-102 to generate the logic state of its output signal O₁. Node logic circuits 101-102 can also have output signals, if needed in particular applications.

Figure 1B is a diagram that depicts an example of an 8-input binary logic tree. The binary logic tree of FIG. 1B can be, as examples, an And-Inverter Cone (AIC) or an OR-Inverter Cone (OIC). The binary logic tree of Figure 1B includes 7 node logic circuits 111-117 that function as nodes in the binary logic tree. Each of the node logic circuits 111-117 includes logic gates, examples of which are disclosed herein with respect to Figures 2A-2D. Node logic circuits 111 and 112 perform logic functions on their input signals I₀-I₁ and I₂-I₃, respectively, to generate output signals that are provided to inputs of node logic circuit 115. Node logic circuits 113 and 114 perform logic functions on their input signals I₄-I₅ and I₆-I₇, respectively, to generate output signals that are provided to inputs of node logic circuit 116. Node logic circuits 115 and 116 perform logic functions on the output signals of node logic circuits 111-112 and 113-114 to generate output signals O₀ and O₁, respectively, that are provided to inputs of node logic circuit 117. Node logic circuit 117 performs a logic function on the output signals O₀ and O₁ of node logic circuits 115-116 to generate the logic state of its output signal Oz. Output signals O₀ and O₁ can also be provided as separate outputs. Node logic circuits 111-114 can also have output signals, if needed in particular applications.

Figure 2A is a diagram that depicts an example of a node logic circuit that can be used as any one or more of the node logic circuits in an And-Inverter Cone (AIC). According to some examples, the node logic circuit shown in FIG. 2A can be in each of the node logic circuits 101-102 and/or 111-114 in the first level of one or both of the binary logic trees of FIGS. 1A and 1B. According to other examples, the node logic circuit shown in FIG. 2A can be used in other binary logic trees. In still other examples, the node logic circuits 101-102 and/or 111-114 can include architectures other than the ones shown in FIGS. 2A-2B. In FIG. 2A, signals A and B are the input signals of the node logic circuit, and signal C is the output signal of the node logic circuit that is generated by performing one or more logic functions on the input signals A and B.

The node logic circuit of FIG. 2A includes 3 inverter circuits 201-203, 3 multiplexer circuits 204-206, and a NAND gate circuit 207. Multiplexer circuit 204 is configurable to provide either input signal A, or an inverted version of input signal A generated by inverter 201, to a first input of NAND gate 207. Multiplexer circuit 205 is configurable to provide either input signal B, or an inverted version of input signal B generated by inverter 202, to a second input of NAND gate 207. NAND gate circuit 207 performs a Boolean NAND logic function on its two input signals to generate the logic state of its output signal. Multiplexer circuit 206 is configurable to provide either the output signal of NAND gate 207, or an inverted version of the output signal of NAND gate 207 generated by inverter 203, to its output as output signal C.

Figure 2B is a diagram that depicts another example of a node logic circuit that can be used as any one or more of the node logic circuits in an And-Inverter Cone (AIC). According to some examples, the node logic circuit shown in FIG. 2B can be in each of the node logic circuits 103 and/or 115-117 in the higher levels of one or both of the binary logic trees of FIGS. 1A and 1B. According to other examples, the node logic circuit shown in FIG. 2B can be used in other binary logic trees. In FIG. 2B, signals A and B are the input signals of the node logic circuit, and signal C is the output signal of the node logic circuit that is generated by performing one or more logic functions on the input signals A and B. The node logic circuit of FIG. 2B includes an inverter circuit 212, a multiplexer circuit 213, and a NAND gate circuit 211. NAND gate circuit 211 performs a Boolean NAND logic function on its two input signals A and B to generate the logic state of its output signal. Multiplexer circuit 213 is configurable to provide either the output signal of NAND gate 211, or an inverted version of the output signal of NAND gate 211 generated by inverter 212, to its output as output signal C.

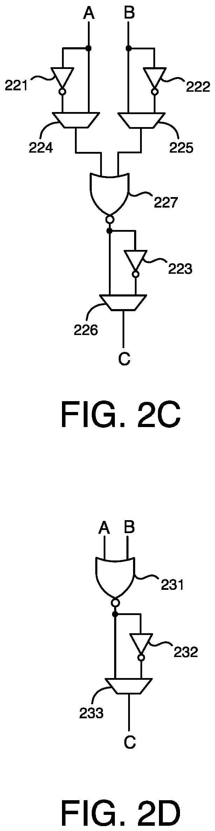

Figure 2C is a diagram that depicts an example of a node logic circuit that can be used as any one or more of the node logic circuits in an OR-Inverter Cone. An Or-Inverter Cone (OIC) is a type of logic gate circuit block. An OIC is designed as a full binary tree of nodes, where each node is a NOR logic gate with programmable output inversion, to implement either a NOR or an OR Boolean logic function of its two inputs.

According to some examples, the node logic circuit shown in FIG. 2C can be used as each of the node logic circuits 101-102 and/or 111-114 in the first level of one or both of the binary logic trees of FIGS. 1A and 1B. In FIG. 2C, signals A and B are the input signals of the node logic circuit, and signal C is the output signal of the node logic circuit that is generated by performing one or more logic functions on the input signals A and B.

The node logic circuit of FIG. 2C includes 3 inverter circuits 221-223, 3 multiplexer circuits 224-226, and a NOR gate circuit 227. Multiplexer circuit 224 is configurable to provide either input signal A, or an inverted version of input signal A generated by inverter 221, to a first input of NOR gate 227. Multiplexer circuit 225 is configurable to provide either input signal B, or an inverted version of input signal B generated by inverter 222, to a second input of NOR gate 227. NOR gate circuit 227 performs a Boolean NOR logic function on its two input signals to generate the logic state of its output signal. Multiplexer circuit 226 is configurable to provide either the output signal of NOR gate 227, or an inverted version of the output signal of NOR gate 227 generated by inverter 223, to its output as output signal C.

Figure 2D is a diagram that depicts another example of a node logic circuit that can be used as any one or more of the node logic circuits in an OR-Inverter Cone (OIC). According to some examples, the node logic circuit shown in FIG. 2D can be used to implement each of the node logic circuits 103 and/or 115-117 in the higher levels of one or both of the binary logic trees of FIGS. 1A and 1B. In FIG. 2D, signals A and B are the input signals of the node logic circuit, and signal C is the output signal of the node logic circuit that is generated by performing one or more logic functions on the input signals A and B. The node logic circuit of FIG. 2D includes an inverter circuit 232, a multiplexer circuit 233, and a NOR gate circuit 231. NOR gate circuit 231 performs a Boolean NOR logic function on its two input signals A and B to generate the logic state of its output signal. Multiplexer circuit 233 is configurable to provide either the output signal of NOR gate 231, or an inverted version of the output signal of NOR gate 231 generated by inverter 232, to its output as output signal C.

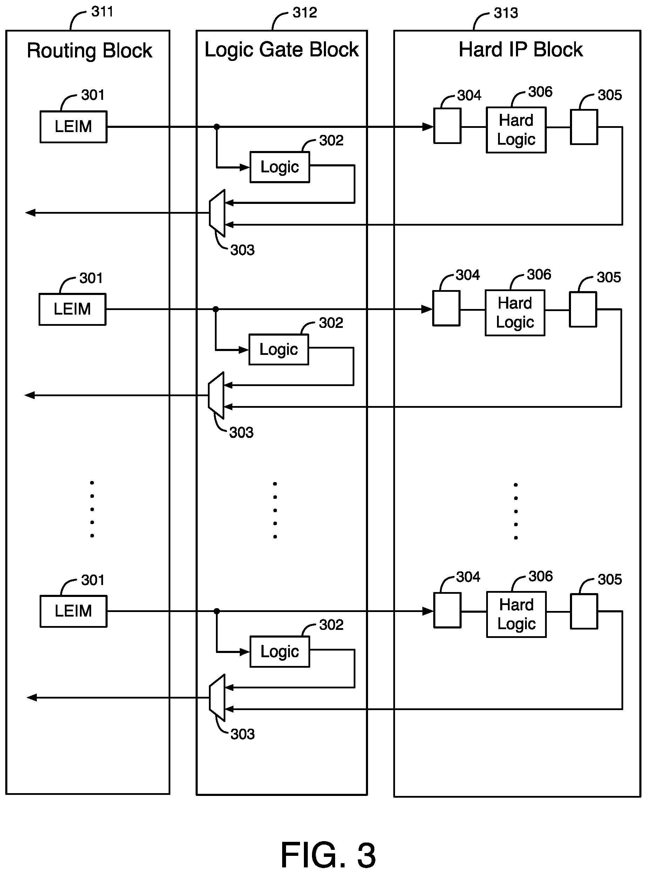

Figure 3 is a diagram that depicts an example of a logic gate block that is coupled in parallel with a hard intellectual property (IP) block in an integrated circuit (IC). Figure 3 illustrates a portion of the IC that includes a routing block 311, a logic gate block 312, and a hard IP block 313. Hard IP block 313 is also referred to herein as a hard logic circuit block. The IC can be, as examples, a configurable IC, a processor IC, a graphics processing unit (GPU), etc. Each of the blocks 311-313 is a circuit block that includes circuits. For example, routing block 311 includes an N number of logic element input multiplexer (LEIM) circuits 301, where N is any positive integer greater than 1. Logic gate block 312 includes an N number of configurable logic gate circuits 302 and an N number of multiplexer circuits 303. Examples of the configurable logic gate circuits 302 include AICs (e.g., the AICs disclosed herein with respect to FIGS. 1A-1B and 2A-2B), OICs (e.g., the OICs disclosed herein with respect to FIGS. 1A-1B and 2C-2D), and other logic gate circuits coupled in binary logic trees or logic cones. The logic gate block 312 can be any size and can be as large as the number of unique inputs of hard IP block 313. Thus, logic gate block 312 can have any number M of configurable logic gate circuits 302 and multiplexer circuits 303, where M is an integer different than N.

Hard IP block 313 includes input register circuits 304, output register circuits 305, and additional hard logic circuits 306 that is coupled between register circuits 304 and 305. Examples of the hard logic circuits 306 in hard IP block 313 include digital signal processing (DSP) circuit blocks and memory circuit blocks.

Each of the LEIMs 301 in routing block 311 receives multiple input signals from one or more configurable logic elements (not shown) in the IC. Each LEIM 301 is configurable to route one of the input signals from a configurable logic element to a corresponding configurable logic gate circuit 302 in logic gate block 312 and to a corresponding input register circuit 304 in the hard IP block 313. The output signal of each configurable logic gate circuit 302 is routed to a first data input of a corresponding multiplexer circuit 303. The output signal of each configurable logic gate circuit 302 can be, for example, an output signal of a binary logic tree or logic cone, such as an AIC or an OIC. The output signal of each output register circuit 305 is routed to a second data input of a corresponding multiplexer circuit 303. Each multiplexer circuit 303 is configurable to route either the output signal of a corresponding configurable logic gate circuit 302 or the output signal of a corresponding output register circuit 305 to additional configurable logic elements (not shown) in the IC through the routing block 311. In other implementations, a register can be added between the output of each configurable logic gate circuit 302 and the first data input of each corresponding multiplexer circuit 303 in order to register the output of the logic gate block 312.

Thus, the logic gate block 312 of FIG. 3 shares the same inputs, outputs, and routing interconnects as the hard IP block 313. The inputs of the hard IP block 313 at input registers 304 are coupled to the inputs of the logic gate block 312 at the inputs of the configurable logic gate circuits 302. The multiplexer circuits 303 are configurable to select and output either the output signals of the hard IP block 313 from all of the output registers 305 or the output signals of the logic gate block 312 from all of the configurable logic gate circuits 302 (e.g., in response to configuration bits).

When a circuit design for the IC uses the hard IP block 313 for performing functions of the circuit design, each of the multiplexer circuits 303 in the logic gate block 312 is configured (e.g., by a configuration bit) to provide the output signal of a corresponding one of the output registers 305 in the hard IP block 313 to the routing block 311. Thus, the multiplexer circuits 303 provide the output signals of the hard IP block 313 to routing block 311. The routing block 311 then transmits the output signals of the output registers 305 in the hard IP block 313 to configurable logic elements in the IC that perform other logic functions of the circuit design. The multiplexer circuits 303 in the logic gate block 312 decouple the outputs of the configurable logic gate circuits 302 from the routing block 311.

When a circuit design for the IC does not use some or all of the inputs or outputs in the hard IP block 313 for performing any functions of the circuit design, the circuit design can instead use the corresponding configurable logic gate circuits 302 in the logic gate block 312 to implement logic functions of the circuit design. Using the configurable logic gate circuits 302 to implement logic functions of the circuit design increases the logic density and reduces the logic area needed to implement the circuit design. In order to enable one or more of the configurable logic gate circuits 302 for use in a circuit design for the IC, the corresponding multiplexer circuits 303 in the logic gate block 312 are configured (e.g., by configuration bits) to provide the output signals of the corresponding configurable logic gate circuits 302 to the routing block 311. Thus, the corresponding multiplexer circuits 303 in the logic gate block 312 transmit the output signals of the corresponding configurable logic gate circuits 302 to routing block 311. The routing block 311 then transmits the output signals of these configurable logic gate circuits 302 (routed through multiplexer circuits 303) to configurable logic elements in the IC that perform other logic functions of the circuit design.

The hard IP block 313 has N inputs at registers 304 and M outputs at registers 305. In some configurations, only a subset of the N inputs of hard IP block 313 and a subset of the M outputs of hard IP block 313 are used. In these implementations, the remaining inputs (and the corresponding available LEIMs 301) of hard IP block 313 and the remaining outputs of hard IP block 313 can be allocated to the logic gate block 312 for implementing some logic functions of a circuit design, instead of wasting the available resources.

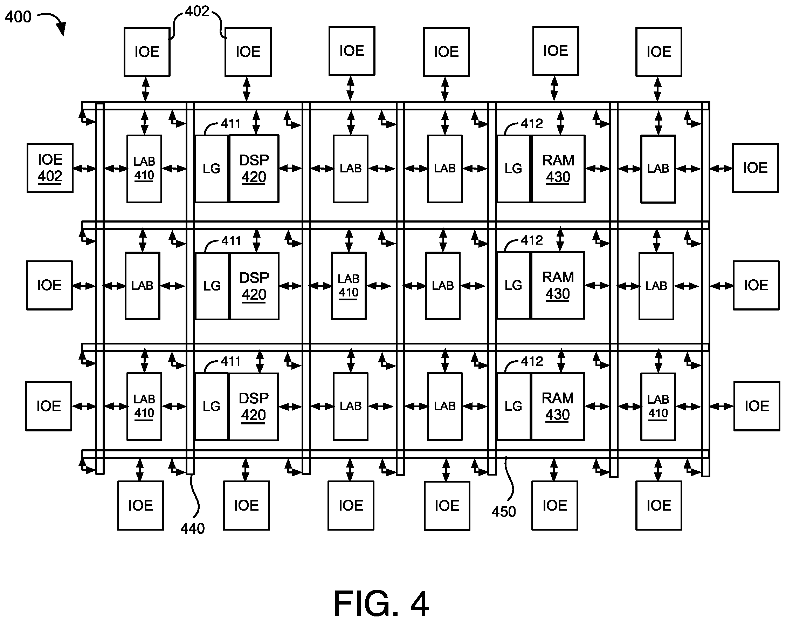

Figure 4 is a diagram of an illustrative example of a configurable integrated circuit (IC) 400. Configurable IC 400 is an example of an IC that can include the circuitry disclosed herein with respect to Figures 1A-1B, 2A-2D, and 3. As shown in FIG. 4, the configurable integrated circuit 400 includes a two-dimensional array of configurable functional blocks, including logic array blocks (LABs) 410 and other functional blocks, such as random access memory (RAM) blocks 430 and digital signal processing (DSP) blocks 420, for example. Configurable functional blocks, such as LABs 410, can include smaller configurable regions (e.g., configurable logic elements, configurable logic blocks, or adaptive logic modules) that receive input signals and perform custom functions on the input signals to produce output signals. RAM blocks 430 and DSP blocks 420 are examples of the hard IP blocks disclosed herein, such as hard IP block 313.

The configurable integrated circuit 400 also includes programmable interconnect circuitry in the form of vertical routing channels 440 (i.e., interconnects formed along a vertical axis of configurable integrated circuit 400) and horizontal routing channels 450 (i.e., interconnects formed along a horizontal axis of configurable integrated circuit 400), each routing channel including at least one track to route at least one wire. One or more of the routing channels 440 and/or 450 can be part of a network-on-chip (NOC) having router circuits.

In addition, the configurable integrated circuit 400 includes logic gate circuit blocks 411 and 412. Each of the logic gate (LG) circuit blocks 411 and 412 includes configurable logic gate circuits (e.g., AICs and/or OICs). The logic gate block 312 of FIG. 3 is an example of each of the logic gate circuit blocks 411 and 412. In the example of FIG. 4, logic gate circuit blocks 411 are coupled in parallel with DSP blocks 420. The logic gate circuit blocks 411 are also coupled to one of the vertical routing channels 440. Also, in the example of FIG. 4, logic gate circuit blocks 412 are coupled in parallel with RAM blocks 430. The logic gate circuit blocks 412 are also coupled to another one of the vertical routing channels 440. When a circuit design for IC 400 does not use any one or more of the DSP blocks 420 and/or the RAM blocks 430 for performing any functions of the circuit design, the circuit design can instead use the configurable logic gate circuits in the logic gate circuit blocks 411-412 that are coupled in parallel with the unused blocks 420/430 to implement logic functions of the circuit design, as described above, for example, with respect to FIG. 3.

In addition, the configurable integrated circuit 400 has input/output elements (IDEs) 402 for driving signals off of configurable integrated circuit 400 and for receiving signals from other devices. Input/output elements 402 can include parallel input/output circuitry, serial data transceiver circuitry, differential receiver and transmitter circuitry, or other circuitry used to connect one integrated circuit to another integrated circuit. Input/output elements 402 can include general purpose input/output (GPIO) circuitry (e.g., on the top and bottoms edges of IC 400), high-speed input/output (HSIO) circuitry (e.g., on the left edge of IC 400), and on-package input/output (OPIOs) circuitry (e.g., on the right edge of IC 400).

As shown, input/output elements 402 can be located around the periphery of the IC. If desired, the configurable integrated circuit 400 can have input/output elements 402 arranged in different ways. For example, input/output elements 402 can form one or more columns of input/output elements that can be located anywhere on the configurable integrated circuit 400 (e.g., distributed evenly across the width of the configurable integrated circuit). If desired, input/output elements 402 can form one or more rows of input/output elements (e.g., distributed across the height of the configurable integrated circuit). Alternatively, input/output elements 402 can form islands of input/output elements that can be distributed over the surface of the configurable integrated circuit 400 or clustered in selected areas.

Note that other routing topologies, besides the topology of the interconnect circuitry depicted in FIG. 4, can be used. For example, the routing topology can include wires that travel diagonally or that travel horizontally and vertically along different parts of their extent as well as wires that are perpendicular to the device plane in the case of three dimensional integrated circuits, and the driver of a wire can be located at a different point than one end of a wire. The routing topology can include global wires that span substantially all of configurable integrated circuit 400, fractional global wires such as wires that span part of configurable integrated circuit 400, staggered wires of a particular length, smaller local wires, or any other suitable interconnection resource arrangement.

Furthermore, it should be understood that examples disclosed herein may be implemented in any type of integrated circuit. If desired, the functional blocks of such an integrated circuit can be arranged in more levels or layers in which multiple functional blocks are interconnected to form still larger blocks. Other device arrangements can use functional blocks that are not arranged in rows and columns.

Configurable integrated circuit 400 can also contain programmable memory elements. The memory elements can be loaded with configuration data (also called programming data) using input/output elements (IDEs) 402. Once loaded, the memory elements each provide a corresponding static control signal that controls the operation of an associated functional block (e.g., LABs 410, DSP 420, RAM 430, LG circuit blocks 411-412, or input/output elements 402).

In a typical scenario, the outputs of the loaded memory elements are applied to the gates of field-effect transistors in a functional block to turn certain transistors on or off and thereby configure the logic in the functional block including the routing paths. Programmable logic circuit elements that are controlled in this way include parts of multiplexers (e.g., multiplexers used for forming routing paths in interconnect circuits), look-up tables, logic arrays, AND, OR, NAND, and NOR logic gates, pass gates, etc.

The memory elements can use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory or programmable memory elements.

The programmable memory elements can be organized in a configuration memory array consisting of rows and columns. A data register that spans across all columns and an address register that spans across all rows can receive configuration data. The configuration data can be shifted onto the data register. When the appropriate address register is asserted, the data register writes the configuration data to the configuration memory elements of the row that was designated by the address register.

Configurable integrated circuit 400 can include configuration memory that is organized in sectors, whereby a sector can include the configuration bits that specify the function and/or interconnections of the subcomponents and wires in or crossing that sector. Each sector can include separate data and address registers.

The configurable IC 400 of FIG. 4 is merely one example of an IC that can be used with embodiments disclosed herein. The embodiments disclosed herein can be used with any suitable electronic integrated circuit or system. For example, the embodiments disclosed herein can be used with numerous types of electronic devices such as processor integrated circuits, central processing units, memory integrated circuits, graphics processing unit integrated circuits, application specific standard products (ASSPs), application specific integrated circuits (ASICs), and configurable logic integrated circuits. Examples of configurable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein can be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein can be stored in non-transitory computer readable storage media. Non-transitory computer readable storage media is tangible computer readable storage media that stores data and software for access at a later time, as opposed to media that only transmits propagating electrical signals (e.g., wires). The software code may sometimes be referred to as software, data, program instructions, instructions, or code. The non-transitory computer readable storage media can, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

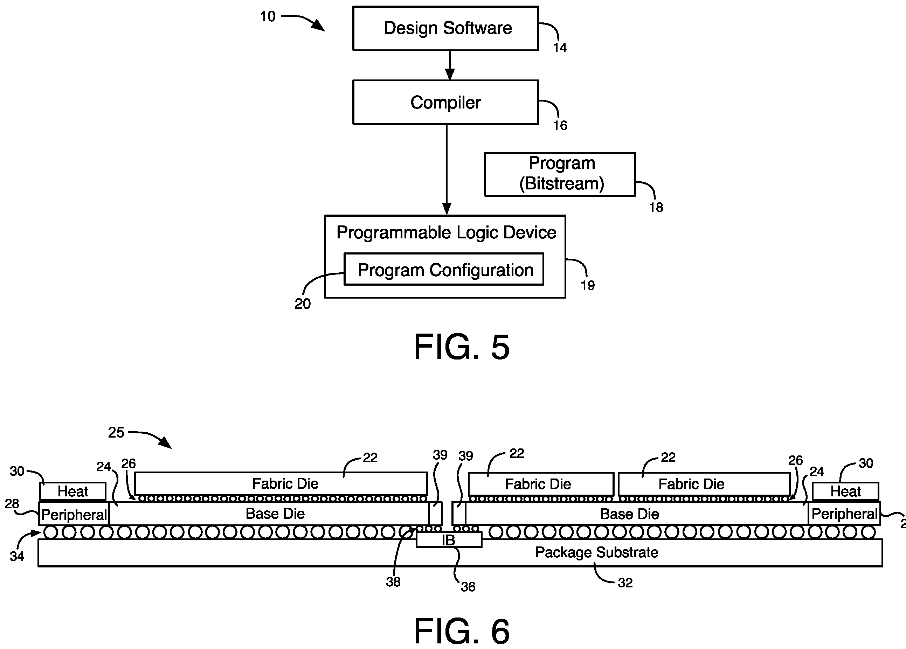

Figure 5 illustrates a block diagram of a system 10 that can be used to implement a circuit design to be programmed onto a programmable logic device 19 using design software. A designer can implement circuit design functionality on an integrated circuit, such as a reconfigurable programmable logic device 19 (e.g., a field programmable gate array (FPGA)). The designer can implement the circuit design to be programmed onto the programmable logic device 19 using design software 14. The design software 14 can use a compiler 16 to generate a low-level circuit-design program (bitstream) 18, sometimes known as a program object file and/or configuration program, that programs the programmable logic device 19. Thus, the compiler 16 can provide machine-readable instructions representative of the circuit design to the programmable logic device 19. For example, the programmable logic device 19 can receive one or more programs (bitstreams) 18 that describe the hardware implementations that should be stored in the programmable logic device 19. A program (bitstream) 18 can be programmed into the programmable logic device 19 as a configuration program 20. The configuration program 20 can, in some cases, represent an accelerator function to perform for machine learning, video processing, voice recognition, image recognition, or other highly specialized task.

In some implementations, a programmable logic device can be any integrated circuit device that includes a programmable logic device with two separate integrated circuit die where at least some of the programmable logic fabric is separated from at least some of the fabric support circuitry that operates the programmable logic fabric. One example of such a programmable logic device is shown in FIG. 6, but many others can be used, and it should be understood that this disclosure is intended to encompass any suitable programmable logic device where programmable logic fabric and fabric support circuitry are at least partially separated on different integrated circuit die.

Figure 6 is a diagram that depicts an example of a programmable logic device 25 that includes three fabric die 22 and two base die 24 that are connected to one another via microbumps 26. In the example of FIG. 6, at least some of the programmable logic fabric of the programmable logic device 25 is in the three fabric die 22, and at least some of the fabric support circuitry that operates the programmable logic fabric is in the two base die 24. For example, some of the circuitry of configurable IC 400 shown in FIG. 4 (e.g., LABs 410, DSP 420, RAM 430, and LG circuit blocks 411-412) can be located in the fabric die 22 and some of the circuitry of IC 400 (e.g., input/output elements 402) can be located in the base die 24.

Although the fabric die 22 and base die 24 appear in a one-to-one relationship or a two-to-one relationship in FIG. 6, other relationships can be used. For example, a single base die 24 can attach to several fabric die 22, or several base die 24 can attach to a single fabric die 22, or several base die 24 can attach to several fabric die 22 (e.g., in an interleaved pattern). Peripheral circuitry 28 can be attached to, embedded within, and/or disposed on top of the base die 24, and heat spreaders 30 can be used to reduce an accumulation of heat on the programmable logic device 25. The heat spreaders 30 can appear above, as pictured, and/or below the package (e.g., as a double-sided heat sink). The base die 24 can attach to a package substrate 32 via conductive bumps 34. In the example of FIG. 6, two pairs of fabric die 22 and base die 24 are shown communicatively connected to one another via an interconnect bridge 36 (e.g., an embedded multi-die interconnect bridge (EMIB)) and microbumps 38 at bridge interfaces 39 in base die 24.

In combination, the fabric die 22 and the base die 24 can operate in combination as a programmable logic device 25 such as a field programmable gate array (FPGA). It should be understood that an FPGA can, for example, represent the type of circuitry, and/or a logical arrangement, of a programmable logic device when both the fabric die 22 and the base die 24 operate in combination. Moreover, an FPGA is discussed herein for the purposes of this example, though it should be understood that any suitable type of programmable logic device can be used.

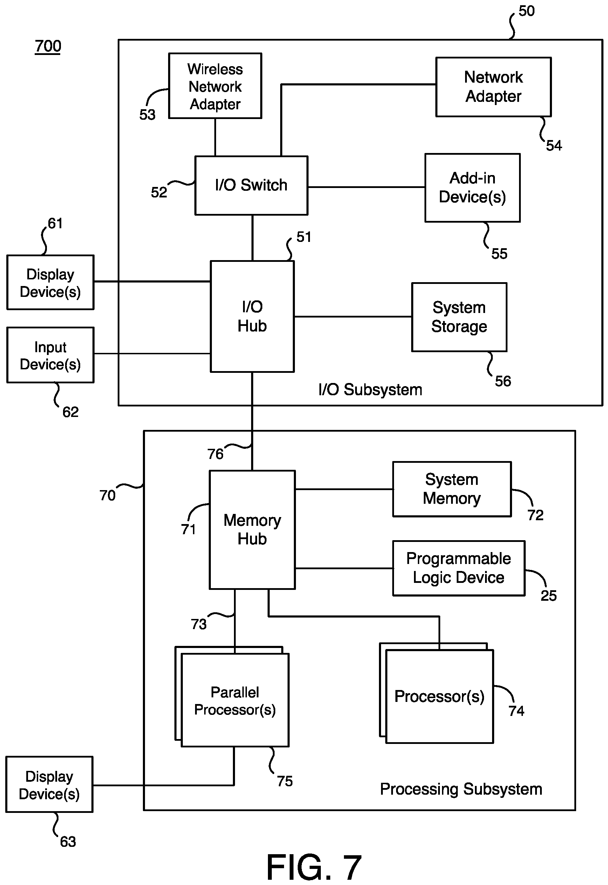

Figure 7 is a block diagram illustrating a computing system 700 configured to implement one or more aspects of the embodiments described herein. The computing system 700 includes a processing subsystem 70 having one or more processor(s) 74, a system memory 72, and a programmable logic device 25 communicating via an interconnection path that can include a memory hub 71. The memory hub 71 can be a separate component within a chipset component or can be integrated within the one or more processor(s) 74. The memory hub 71 couples with an input/output (I/O) subsystem 50 via a communication link 76. The I/O subsystem 50 includes an input/output (I/O) hub 51 that can enable the computing system 700 to receive input from one or more input device(s) 62. Additionally, the I/O hub 51 can enable a display controller, which can be included in the one or more processor(s) 74, to provide outputs to one or more display device(s) 61. In one embodiment, the one or more display device(s) 61 coupled with the I/O hub 51 can include a local, internal, or embedded display device.

In one embodiment, the processing subsystem 70 includes one or more parallel processor(s) 75 coupled to memory hub 71 via a bus or other communication link 73. The communication link 73 can use one of any number of standards based communication link technologies or protocols, such as, but not limited to, PCI Express, or can be a vendor specific communications interface or communications fabric. In one embodiment, the one or more parallel processor(s) 75 form a computationally focused parallel or vector processing system that can include a large number of processing cores and/or processing clusters, such as a many integrated core (MIC) processor. In one embodiment, the one or more parallel processor(s) 75 form a graphics processing subsystem that can output pixels to one of the one or more display device(s) 61 coupled via the I/O Hub 51. The one or more parallel processor(s) 75 can also include a display controller and display interface (not shown) to enable a direct connection to one or more display device(s) 63.

Within the I/O subsystem 50, a system storage unit 56 can connect to the I/O hub 51 to provide a storage mechanism for the computing system 700. An I/O switch 52 can be used to provide an interface mechanism to enable connections between the I/O hub 51 and other components, such as a network adapter 54 and/or a wireless network adapter 53 that can be integrated into the platform, and various other devices that can be added via one or more add-in device(s) 55. The network adapter 54 can be an Ethernet adapter or another wired network adapter. The wireless network adapter 53 can include one or more of a Wi-Fi, Bluetooth, near field communication (NFC), or other network device that includes one or more wireless radios.

The computing system 700 can include other components not shown in FIG. 7, including other port connections, optical storage drives, video capture devices, and the like, that can also be connected to the I/O hub 51. Communication paths interconnecting the various components in FIG. 7 can be implemented using any suitable protocols, such as PCI (Peripheral Component Interconnect) based protocols (e.g., PCI-Express), or any other bus or point-to-point communication interfaces and/or protocol(s), such as the NV-Link high-speed interconnect, or interconnect protocols known in the art.

In one embodiment, the one or more parallel processor(s) 75 incorporate circuitry optimized for graphics and video processing, including, for example, video output circuitry, and constitutes a graphics processing unit (GPU). In another embodiment, the one or more parallel processor(s) 75 incorporate circuitry optimized for general purpose processing, while preserving the underlying computational architecture. In yet another embodiment, components of the computing system 700 can be integrated with one or more other system elements on a single integrated circuit. For example, the one or more parallel processor(s) 75, memory hub 71, processor(s) 74, and I/O hub 51 can be integrated into a system on chip (SoC) integrated circuit. Alternatively, the components of the computing system 700 can be integrated into a single package to form a system in package (SIP) configuration. In one embodiment, at least a portion of the components of the computing system 700 can be integrated into a multi-chip module (MCM), which can be interconnected with other multi-chip modules into a modular computing system.

The computing system 700 shown herein is illustrative. Other variations and modifications are also possible. The connection topology, including the number and arrangement of bridges, the number of processor(s) 74, and the number of parallel processor(s) 75, can be modified as desired. For instance, in some embodiments, system memory 72 is connected to the processor(s) 74 directly rather than through a bridge, while other devices communicate with system memory 72 via the memory hub 71 and the processor(s) 74. In other alternative topologies, the parallel processor(s) 75 are connected to the I/O hub 51 or directly to one of the one or more processor(s) 74, rather than to the memory hub 71. In other embodiments, the I/O hub 51 and memory hub 71 can be integrated into a single chip. Some embodiments can include two or more sets of processor(s) 74 attached via multiple sockets, which can couple with two or more instances of the parallel processor(s) 75.

Some of the particular components shown herein are optional and may not be included in all implementations of the computing system 700. For example, any number of add-in cards or peripherals can be supported, or some components can be eliminated. Furthermore, some architectures can use different terminology for components similar to those illustrated in FIG. 7. For example, the memory hub 71 can be referred to as a Northbridge in some architectures, while the I/O hub 51 can be referred to as a Southbridge.

Additional examples are now described. Example 1 is an integrated circuit comprises: a hard logic circuit block; a routing block; and a logic gate circuit block comprising configurable logic gate circuits, wherein the logic gate circuit block is configurable to provide either first output signals of the configurable logic gate circuits to the routing block or second output signals of the hard logic circuit block to the routing block.

In Example 2, the integrated circuit of Example 1 can optionally include, wherein the hard logic circuit block is coupled in parallel with the logic gate circuit block.

In Example 3, the integrated circuit of any one of Examples 1-2 can optionally include, wherein the logic gate circuit block comprises multiplexer circuits that are configurable to provide either the first output signals or the second output signals to the routing block.

In Example 4, the integrated circuit of any one of Examples 1-3 can optionally include, wherein the configurable logic gate circuits comprise binary logic trees.

In Example 5, the integrated circuit of Example 4 can optionally include, wherein the binary logic trees comprise an And-Inverter Cone.

In Example 6, the integrated circuit of any one of Examples 4-5 can optionally include, wherein the binary logic trees comprise an OR-Inverter Cone.

In Example 7, the integrated circuit of any one of Examples 1-6 can optionally include, wherein the hard logic circuit block comprises one of a memory circuit block or a digital signal processing circuit block.

In Example 8, the integrated circuit of any one of Examples 1-7 can optionally include, wherein the routing block comprises multiplexer circuits configurable to route input signals to first inputs of the configurable logic gate circuits and to second inputs of the hard logic circuit block.

In Example 9, the integrated circuit of any one of Examples 1-8 can optionally include, wherein the integrated circuit is a configurable integrated circuit, and wherein the logic gate circuit block is configurable to provide the first output signals to the routing block when the integrated circuit is configured with a circuit design that uses the configurable logic gate circuits for performing functions of the circuit design.

Example 10 is a method for manufacturing an integrated circuit, the method comprising:
providing a hard logic circuit block in the integrated circuit; providing a routing block in the integrated circuit; and providing a logic gate circuit block in the integrated circuit, wherein the logic gate circuit block comprises first multiplexer circuits and configurable logic gate circuits,
and wherein the first multiplexer circuits are configurable to transmit either first output signals generated by the configurable logic gate circuits or second output signals generated by the hard logic circuit block to the routing block.

In Example 11, the method of Example 10 further comprises: providing second multiplexer circuits in the routing block that are configurable to route input signals to first inputs of the configurable logic gate circuits and to second inputs of the hard logic circuit block.

In Example 12, the method of any one of Examples 10-11 can optionally include, wherein the configurable logic gate circuits comprise binary logic tree circuits.

In Example 13, the method of any one of Examples 10-12 can optionally include, wherein the configurable logic gate circuits comprise at least one of an And-Inverter Cone or an OR-Inverter Cone.

In Example 14, the method of any one of Examples 10-13 can optionally include, wherein the hard logic circuit block comprises one of a memory circuit block or a digital signal processing circuit block.

In Example 15, the method of any one of Examples 10-14 can optionally include, wherein the integrated circuit is a configurable integrated circuit, and wherein the first multiplexer circuits are configurable to provide the second output signals to the routing block when the integrated circuit is configured with a circuit design that uses the hard logic circuit block for performing functions of the circuit design.

Example 16 is a configurable integrated circuit comprising: a hard intellectual property circuit block; a routing block; and a logic gate circuit block comprising first multiplexer circuits and configurable logic gate circuits, wherein the first multiplexer circuits comprise inputs coupled to first outputs of the configurable logic gate circuits and to second outputs of the hard intellectual property circuit block, and wherein the first multiplexer circuits comprise third outputs coupled to the routing block.

In Example 17, the configurable integrated circuit of Example 16 can optionally include, wherein the configurable logic gate circuits comprise binary logic trees.

In Example 18, the configurable integrated circuit of any one of Examples 16-17 can optionally include, wherein the first multiplexer circuits are configurable to provide either first output signals from the first outputs of the configurable logic gate circuits to the routing block or second output signals from the second outputs of the hard intellectual property circuit block to the routing block.

In Example 19, the configurable integrated circuit of any one of Examples 16-18 can optionally include, wherein the hard intellectual property circuit block comprises one of a memory circuit block or a digital signal processing circuit block.

In Example 20, the configurable integrated circuit of any one of Examples 16-19 can optionally include, wherein the logic gate circuit block is configurable to provide output signals from the first outputs of the configurable logic gate circuits to the routing block when the configurable integrated circuit is configured with a circuit design that uses the configurable logic gate circuits to perform functions of the circuit design.

The foregoing description of the exemplary embodiments has been presented for the purpose of illustration. The foregoing description is not intended to be exhaustive or to be limiting to the examples disclosed herein. The foregoing is merely illustrative of the principles of this disclosure and various modifications can be made by those skilled in the art. The foregoing embodiments may be implemented individually or in any combination.

## Claims

1. An integrated circuit comprising:
a hard logic circuit block;
a routing block; and
a logic gate circuit block comprising configurable logic gate circuits, wherein the logic gate circuit block is configurable to provide either first output signals of the configurable logic gate circuits to the routing block or second output signals of the hard logic circuit block to the routing block.

2. The integrated circuit of claim 1, wherein the hard logic circuit block is coupled in parallel with the logic gate circuit block.

3. The integrated circuit of any one of claims 1-2, wherein the logic gate circuit block comprises multiplexer circuits that are configurable to provide either the first output signals or the second output signals to the routing block.

4. The integrated circuit of any one of claims 1-3, wherein the configurable logic gate circuits comprise binary logic trees.

5. The integrated circuit of claim 4, wherein the binary logic trees comprise an And-Inverter Cone.

6. The integrated circuit of any one of claims 4-5, wherein the binary logic trees comprise an OR-Inverter Cone.

7. The integrated circuit of any one of claims 1-6, wherein the hard logic circuit block comprises one of a memory circuit block or a digital signal processing circuit block.

8. The integrated circuit of any one of claims 1-7, wherein the routing block comprises multiplexer circuits configurable to route input signals to first inputs of the configurable logic gate circuits and to second inputs of the hard logic circuit block.

9. The integrated circuit of any one of claims 1-8, wherein the integrated circuit is a configurable integrated circuit, and wherein the logic gate circuit block is configurable to provide the first output signals to the routing block when the integrated circuit is configured with a circuit design that uses the configurable logic gate circuits for performing functions of the circuit design.

10. A method for manufacturing an integrated circuit, the method comprising:
providing a hard logic circuit block in the integrated circuit;
providing a routing block in the integrated circuit; and
providing a logic gate circuit block in the integrated circuit, wherein the logic gate circuit block comprises first multiplexer circuits and configurable logic gate circuits, and wherein the first multiplexer circuits are configurable to transmit either first output signals generated by the configurable logic gate circuits or second output signals generated by the hard logic circuit block to the routing block.

11. The method of claim 10 further comprising:
providing second multiplexer circuits in the routing block that are configurable to route input signals to first inputs of the configurable logic gate circuits and to second inputs of the hard logic circuit block.

12. The method of any one of claims 10-11, wherein the configurable logic gate circuits comprise binary logic tree circuits.

13. The method of any one of claims 10-12, wherein the configurable logic gate circuits comprise at least one of an And-Inverter Cone or an OR-Inverter Cone.

14. The method of any one of claims 10-13, wherein the hard logic circuit block comprises one of a memory circuit block or a digital signal processing circuit block.

15. The method of any one of claims 10-14, wherein the integrated circuit is a configurable integrated circuit, and wherein the first multiplexer circuits are configurable to provide the second output signals to the routing block when the integrated circuit is configured with a circuit design that uses the hard logic circuit block for performing functions of the circuit design.
